# EUROPEAN PATENT APPLICATION

(11) **EP 4 501 537 A1**
(43) Date of publication of application: **05.02.2025**
(21) Application number: 23777581.2
(22) Date of filing: 09.01.2023
(51) Int. Cl.: B24B 7/22, B24B 41/06, B65G 47/52, H01L 21/677

(54) **WAFER POLISHING SYSTEM, AND LOADING METHOD AND USE METHOD THEREFOR**

(30) Priority: 29.03.2022 CN 202210316152
(71) Applicant: Hangzhou Sizone Electronic Technology Inc., Hangzhou Zhejiang 311300 (CN)
(72) Inventor: XU, Xiaoyu, Hangzhou, Zhejiang 311300 (CN); ZHENG, Dongzhou, Hangzhou, Zhejiang 311300 (CN); YANG, Yuansi, Hangzhou, Zhejiang 311300 (CN)
(74) Representative: Becker, Eberhard
(86) International application number: PCT/CN2023/071166
(87) International publication number: WO 2023/185202

(57) **Abstract**

Disclosed in the present invention is a wafer polishing system, comprising: a wafer transfer apparatus that comprises a fixing base and a carrying table, the fixing base being capable of driving the carrying table to move in a wafer transmission channel along an X-axis direction; and a polishing module that is disposed at a side edge of the wafer transmission channel and is capable of obtaining a wafer from the carrying table for polishing. A connecting mechanism is provided between the fixing base and the carrying table, the connecting mechanism has a portion connected to the fixing base and a portion connected to the carrying table; when the two portions of the connecting mechanism are in connection, the carrying table and the fixing base are positionlimited, and the connecting mechanism can move in the plane where the X axis and a Y axis are located, so as to drive the carrying table to move to a target position. Also disclosed in the present invention is a loading method for the wafer polishing system. Further disclosed in the present invention is a use method for the wafer polishing system. According to the present invention, the movement of the carrying table to the target position is effectively ensured, superposition adjustment is performed in two dimensions, and the connection range is wide; connection and position limiting can be performed in different processes, and the application is flexible.

## Description

### Technical Field

The invention belongs to the technical field of fabrication of semiconductor integrated circuit chips, and particularly relates to a wafer polishing system, and a loading method and using method thereof.

### Background Art

Chemical mechanical planarization (CMP) equipment typically comprises a semiconductor equipment front end module (EFEM), a cleaning unit and a polishing unit. The EFEM mainly comprises a cassette for storing wafers, a robot arm for transferring wafers, and an air purification system. The cleaning unit mainly comprises a varied number of megasonic cleaning components, scrubbing cleaning components, drying components and devices for transferring wafers between the components. The polishing unit mainly comprises a polishing platen, a polishing head, a polishing liquid supply system and a polishing pad trimming system.

With the upgrading of CMP equipment, one piece of CMP equipment generally comprises multiple polishing units to achieve a higher polishing yield. During the wafer processing process, the transfer of wafers between different modules has a great influence on the overall polishing yield of the CMP equipment. The transfer of wafers between the polishing units and the outside as well as between the polishing units is implemented generally by means of a wafer loader, a robot arm and other devices.

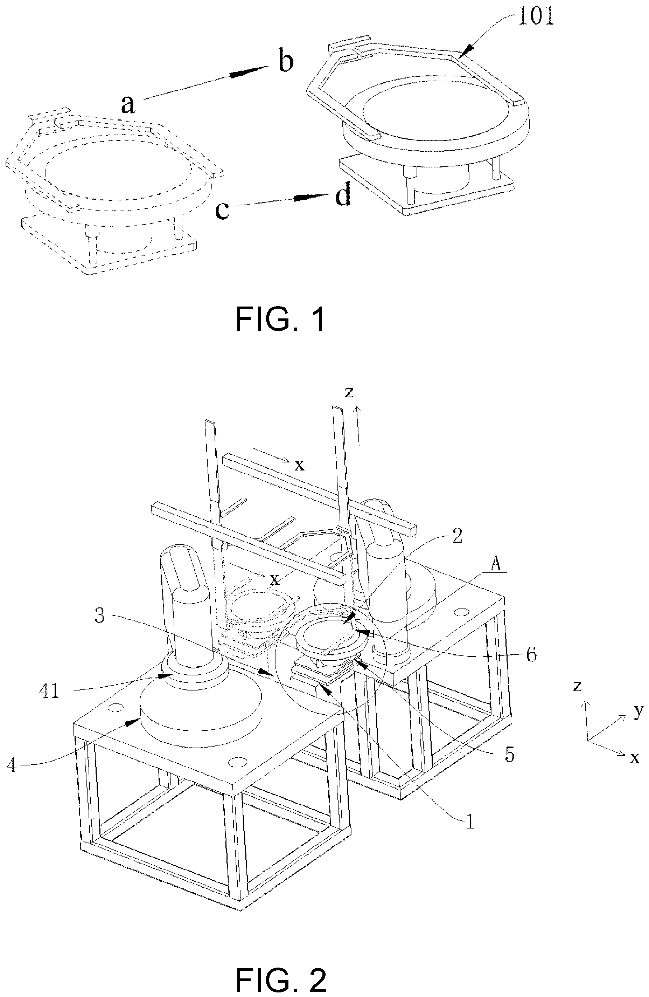

As shown in FIG. 1, generally, the wafer loader and the robot arm have multiple stations, the robot arm 101 moves from a to b, and the wafer loader moves from c to d. However, due to the presence of various errors, the line ab and the line cd are not completely parallel, and the robot arm may deviate from the pre-designed state when coming in contact with a wafer, leading to a difficulty in wafer pickup and even damage to the wafer.

### SUMMARY OF THE INVENTION

To overcome the defects in the prior art, the invention provides a wafer polishing system and a loading method and using method therefor to overcome the deviation between a robot arm and a wafer loader and guarantee effective wafer pickup and placement of the robot arm.

The technical solution adopted by the invention to solve the technical problems is as follows: a wafer polishing system comprises:
a wafer transfer device, the wafer transferring device comprising a fixed base and a wafer loader for carrying a wafer, and the fixed base being able to drive the wafer loader to move in a wafer transfer channel in an X-axis direction; and
a polishing module, the polishing module being arranged on a side of the wafer transfer channel and being able to pick up the wafer from the wafer loader to polish the wafer;
wherein, a connection mechanism is arranged between the fixed base and the wafer loader, and the connection mechanism has a portion connected to the fixed base and a portion connected to the wafer loader;
when the two portions of the connection mechanism are connected, the wafer loader and the fixed base are limited, and the connection mechanism is able to move in a plane where an X-axis and a Y-axis are located to drive the wafer loader to move to a target position in the plane where the X-axis and the Y-axis are located.

Further, the connection mechanism comprises:
a sliding plate movably arranged on the fixed base by means of a sliding rail;
an upper connection portion arranged on the wafer loader; and
a lower connection portion arranged on the moving plate;
wherein, the sliding plate is able to move in the plane where the X-axis and the Y-axis are located to drive the wafer loader to move to the target position by means of an axial connection of the lower connection portion and the upper connection portion.

Further, the upper connection portion at least comprises a first section and a second section which are arranged coaxially, an inner diameter of the first section matches an outer diameter of the lower connection portion, an inner diameter of the second section is greater than the inner diameter of the first section, and the second section is close to the lower connection portion;
or, the lower connection portion at least comprises a first section and a second section which are arranged coaxially, an inner diameter of the first section matches an outer diameter of the upper connection portion, an inner diameter of the second section is greater than the inner diameter of the first section, and the second section is close to the upper connection portion.

Further, the wafer loader has a micro-motion state where the wafer loader is able to float at least in the X-axis direction and a Y-axis direction, and the wafer loader in the micro-motion state is limited with respect to the fixed base by means of the connection mechanism to be switched from the micro-motion state to a stationary state.

Further, a slot tangent to an eccentric cam is formed in the moving plate, and when the eccentric cam is driven to rotate by means of an external force, the moving plate moves in the plane where the X-axis and the Y-axis are located.

Further, the wafer polishing system further comprises a storage unit used for storing rotation angles of the eccentric cam at different stations.

Further, the target position is a position exactly opposite to a clamping jaw to overcome a deviation of the wafer loader in the plane where the X-axis and the Y-axis are located when the fixed base moves in the X-axis direction to different stations.

Further, at least two clamping jaws are arranged, at least one clamping jaw is used for picking and placing non-polished wafers, and at least another clamping jaw is used for picking and placing polished wafers.

The invention further discloses a loading method for the wafer polishing system, comprising:
a step of driving one portion of the connection mechanism to move with respect to the fixed base in the plane where the X-axis and the Y-axis are located;
a step of driving the wafer loader to ascend or descend in Z-axis direction to be close to the fixed base; and
a step of axially connecting the connection mechanism and the wafer loader;
wherein, the three steps are performed sequentially, in an overlapped manner, or synchronously;
in this way, the wafer loader is moved to the target position in the plane where the X-axis and the Y-axis are located.

Further, the loading method for the wafer polishing system comprises:
a step of driving the moving plate to move with respect to the fixed base in the plane where the X-axis and the Y-axis are located;
a step of driving the wafer loader to ascend or descend in the Z-axis direction to be close to the fixed base; and
a step of axially connecting the upper connection portion on a lower side of the wafer loader and the lower connection portion on an upper side of the moving plate;
wherein, the three steps are performed sequentially, in an overlapped manner, or synchronously;
in this way, the wafer loader is moved to the target position in the plane where the X-axis and the Y-axis are located.

Further, the loading method for the wafer polishing system comprises:
a step of driving the moving plate to move with respect to the fixed base in the plane where the X-axis and the Y-axis are located;
a step of driving the wafer loader to ascend or descend in the Z-axis direction to be close to the fixed base;
a step of driving the moving plate to further move with respect to the fixed base in the plane where the X-axis and the Y-axis are located and driving the wafer loader to further ascend or descend in the Z-axis direction to be close to the fixed base until the upper connection portion and the lower connection portion are axially connected;
a step of stopping the moving plate from moving; and
a step of stopping the wafer loader from ascending or descending.

Further, the loading method for the wafer polishing system comprises:
a step of driving the moving plate to move with respect to the fixed base in the plane where the X-axis and the Y-axis are located to reach the target position; and
a step of driving the wafer loader to ascend or descend in the Z-axis direction to be close to the fixed base unit the upper connection portion and the lower connection portion are axially connected.

Further, the loading method for the wafer polishing system comprises:
a step of driving the wafer loader to ascend or descend in the Z-axis direction to be close to the fixed base until the upper connection portion and the lower connection portion are connected; and
a step of driving, by the moving plate, the wafer loader to move with respect to the fixed base in the Y-axis direction to reach the target position.

The invention further discloses a using method for the polishing wafer system, comprising:
a step of connecting and limiting the wafer loader and the fixed base by means of the connection mechanism to allow the wafer loader to be located at a position exactly opposite to a target position of a clamping jaw and placing the wafer on the wafer loader by the clamping jaw;
a step of rotating a polishing head of the polishing module to a position above the wafer loader, switching the wafer loader to the micro-motion state where the wafer loader is able to float in the X-axis direction and the Y-axis direction and taking the wafer from the wafer loader by the polishing head; and
a step of connecting and limiting the wafer loader and the fixed base by means of the connection mechanism and driving the wafer loader to move in the X-axis direction to a different station;
wherein, the three steps are performed sequentially; or, any one, two or more of the three steps are combined to be performed; or one, two or more of the three steps are combined repeatedly to be performed;
in this way, a deviation of the wafer loader in the X-axis direction and the Y-axis direction is eliminated to align the wafer loader with the clamping jaw.

Further, comprises the following method: a step of moving, after the two portions of the connection mechanism are connected, the connection mechanism in the plane where the X-axis and the Y-axis are located to allow the wafer loader to be located at a position exactly opposite to the clamping jaw, and placing the wafer on the wafer loader by the clamping jaw.

Further, comprises the following method:
a step of connecting and limiting the wafer loader and the fixed base by means of the connection mechanism to allow the wafer loader be located at a position exactly opposite to the clamping jaw;
a step of driving the clamping jaw, together with the wafer, to move in the X-axis direction to a position above the wafer loader and then driving the clamping jaw to ascend or descend in a Z-axis direction to place the wafer on the wafer loader;
a step of rotating the polishing head to a position above the wafer loader;
a step of driving the wafer loader to ascend or descend in the Z-axis direction to be switched to the micro-motion state where the wafer loader is able to float in the X-axis direction and the Y-axis direction, and moving the wafer loader to a position corresponding to the polishing head under the constraint of a limiting structure;
a step of driving the wafer loader to ascend or descend in the Z-axis direction, and connecting and limiting the wafer loader and the fixed base by means of the connection mechanism;
a step of taking the wafer from the wafer loader by the polishing head for polishing;
a step of moving the wafer loader in the X-axis direction to another station;
a step of driving the wafer loader to ascend or descend in the Z-axis direction to be switched to the micro-motion state where the wafer loader is able to float in the X-axis direction and the Y-axis direction;
a step of driving, by means of an external force, one portion of the connection mechanism to move to the target position in the plane where the X-axis and the Y-axis are located; and
a step of driving the wafer loader to ascend or descend in the Z-axis direction, and connecting and limiting the wafer loader and the fixed base by means of the connection mechanism to eliminate a deviation in the X-axis direction and the Y-axis direction to align the wafer loader with another clamping jaw.

Further, comprises the following method:
a step of limiting and connecting the wafer loader and the fixed base by means of the connection mechanism to allow the wafer loader to be located at a position exactly opposite to the target position of the clamping jaw;
a step of driving the clamping jaw, together with the wafer, to move in the X-axis direction to a position above the wafer loader, driving the clamping jaw to ascend or descend in Z-axis direction to place the wafer on the wafer loader, and moving the clamping jaw away;
a step of rotating the polishing head to a position above the wafer loader, and driving the wafer loader to ascend in the Z-axis direction and float in the plane where the X-axis and the Y-axis are located to be aligned with the polishing head;
a step of taking the wafer from the wafer loader by the polishing head;
a step of driving the wafer loader to ascend or descend in the Z-axis direction, and connecting and limiting the wafer loader and the fixed base to a target position of the wafer loader on a next station, wherein the target position is stored in the storage unit;
a step of moving the polishing head, together with the wafer, to a polishing station of the polishing module; and
a step of moving the wafer loader in the X-axis direction to another station.

The invention has the following beneficial effects: 1) no matter whether the fixed base moves to different stations or the fixed base and the wafer loader are limited and connected at the same station, it can be effectively guaranteed that the wafer loader can move to the target position; 2) the connection mechanism can realize adjustment in two dimensions by a relative movement of the moving plate with respect to the fixed base by means of the sliding rail and an axial connection between the upper connection portion and the lower connection portion to connect the wafer loader and the fixed base within a wide range to adapt to different usage scenarios, such that the application range is wide; 3) the connection structure has a relatively simple structure and is easy to assemble, and the driving structure is simple; 4) connection and limiting can be performed by means of the connection mechanism in different processes, such that flexible use can be realized; 5) under the precondition that the connection of the polishing head and the wafer transfer device is not affected, the wafer transfer device and the clamping jaw can be accurately connected, such that the structure is compact, and accurate dual connection at all stations can be realized; 6) the connection mechanism is arranged on the wafer transfer device and can move dynamically with the wafer transfer device, such that the position of the wafer transfer device at different stations can be adjusted; 7) multiple positions of the connection mechanism on a certain station can be recorded for real-time position adjustment to satisfy the deviation requirement of multiple clamping jaws at the station; and 8) the adaptivity to robot arms is high, and position alignment can be realized in case of multiple robot arms at one station, one robot arm at multiple stations and multiple robot arms at multiple stations.

### BRIEF DESCRIPTION OF THE DRAWINGS

FIG. 1 is a schematic diagram of a deviation generated when a robot arm and a wafer loader respectively move to a different station in the prior art.
FIG. 2 is a schematic structural view of a wafer polishing system according to the invention.
FIG. 3 is an enlarged view of part A in FIG. 2.
FIG. 4 is a schematic diagram of a connection mechanism in a case where two portions of the connection mechanism are not connected according to the invention.
FIG. 5 is a schematic diagram of the connection mechanism in a case where the two portions of the connection mechanism are connected according to the invention.
FIG. 6 is a schematic diagram of the connection mechanism according to the invention, wherein an eccentric cam is illustrated.
FIG. 7 is a schematic structural view of a wafer loader and a moving plate in a case where an upper connection portion and a lower connection portion are not connected according to the invention.
FIG. 8 is a schematic structural view of the wafer loader and the moving plate in a case where the upper connection portions and the lower connection portions are connected according to the invention.
FIG. 9 is a schematic structural view of the connecting process of the upper connection portion and the lower connection portion according to the invention.
FIG. 10 is a top structural view of the moving plate according to the invention.
FIG. 11 is a schematic diagram of overcoming a deviation according to the invention.

### DETAILED DESCRIPTION OF THE EMBODIMENTS

To allow those skilled in the art to have a better understanding of the technical solutions of the invention, the technical solutions in the embodiments of the invention will be clearly and completely described below in conjunction with the accompanying drawings of the embodiments of the invention. Obviously, the embodiments described below are merely illustrative ones, and are not all possible ones of the invention. All other embodiments obtained by ordinarily skilled in the art based on the following ones without creative labor should also fall within the protection scope of the invention.

As shown in FIG. 2, a wafer polishing system comprises a wafer transfer device 1 used for transferring wafers in a wafer transfer channel 3, a polishing module 4 arranged on one side of the wafer transfer channel 3, and a clamping mechanism provided with clamping jaws 6. As shown by the coordinate system in FIG. 2, the length extension direction of the wafer transfer channel 3 is defined as an X-axis direction, the width direction of the wafer transfer channel 3 is defined as a Y-axis direction, and the direction of a plane where the X-axis and the Y-axis are located in defined as a Z-axis direction. The wafer transfer device 1 comprises a fixed base 11 and a wafer loader 12 used for carrying a wafer 2, and the fixed base 11 is able to drive the wafer loader 12 to move in the wafer transfer channel 3 in the X-axis direction. The polishing module 4 is able to pick up the wafer 2 from the wafer loader 12 to polish the wafer 2.

A connection mechanism 5 is arranged between the fixed base 11 and the wafer loader 12, one portion of the connection mechanism 5 is connected to the fixed base 11, the other portion of the connection mechanism 5 is connected to the wafer loader 12, and when the two portions of the connection mechanism 5 are connected, the wafer loader 12 and the fixed base 11 are limited; and the connection mechanism 5 is able to move in the plane where the X-axis and the Y-axis are located to drive the wafer loader 12 to move to a target position in the plane where the X-axis and the Y-axis are located.

Here, the wafer loader 12 and the fixed base 11 are limited, which means that the wafer loader 12 and the fixed base 11 will not move relatively, particularly in the plane where the X-axis and the Y-axis are located. In this embodiment, the position of the fixed base 11 is fixed relatively, and in a case where the two portions of the connection mechanism 5 are not connected, although the fixed base 11 and the wafer loader 12 are connected by means of an existing structure, they are in a relatively floating state and can move slightly with respect to each other.

Hence, in the presence of the connection mechanism 5, when the wafer loader 12 is not located at the target position (the target position may be a position exactly opposite to the clamping jaws 6 of the clamping mechanism or may be other positions), the position of the fixed base 11 is fixed relatively; after the two portions of the connection mechanism 5 are connected, the position of the connection mechanism 5 and the position of the wafer loader 12 are fixed relatively, and then the connection mechanism 5 moves with respect to the fixed base 11 in the plane where the X-axis and the Y-axis are located, to drive the wafer loader 12 to move to the target position. Or, one portion of the connection mechanism 5 moves first in the plane where the X-axis and the Y-axis are located, and after position of the connection mechanism 5 and the position of the wafer loader 12 are fixed relatively, the two portions of the connection mechanism 5 are connected to allow the wafer loader 12 to move to the target position. The specific sequence is not limited.

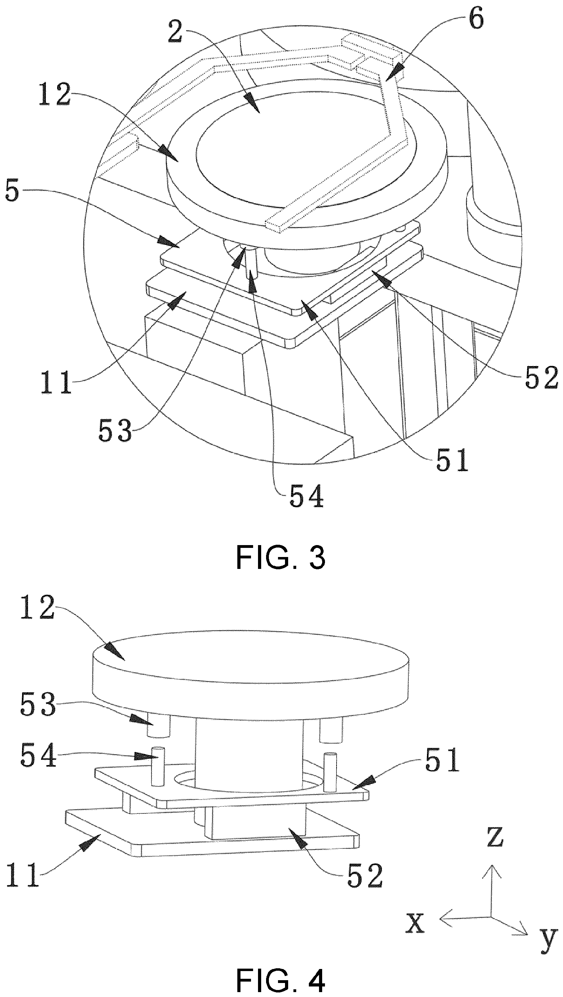

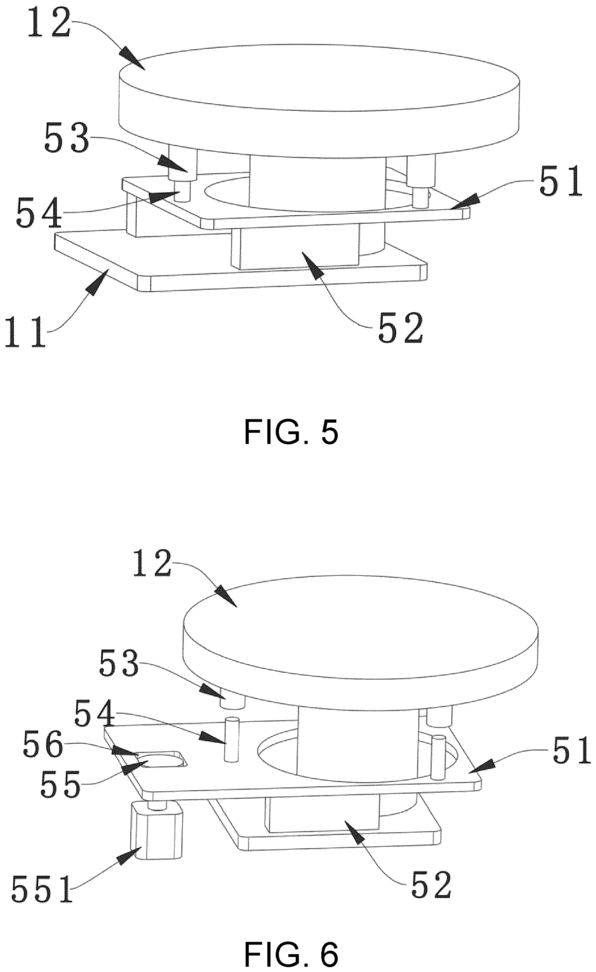

As shown in FIGS. 2-8, the connection mechanism 5 comprises a moving plate 51, at least one upper connection portion 53 and at least one lower connection portion 54. The moving plate 51 is movably arranged on the fixed base 11 by means of a sliding rail 52, that is, the moving plate 51 is able to slide with respect to the fixed base 11 in the plane where the X-axis and the Y-axis are located by means of the sliding rail 52, wherein the realization of the function of the sliding rail 52 belongs to the prior art and will not be repeated anymore. The upper connection portion 53 is arranged on the wafer loader 12. Specifically, in this embodiment, the upper connection portion 53 is arranged on a lower surface of the wafer loader 12. Of course, in other embodiments, the upper connection portion 53 may be arranged at other positions of the wafer loader 12. The lower connection portion 54 is arranged on the moving plate 51. Specifically, in this embodiment, the lower connection portion 54 is arranged on an upper surface of the moving plate 51. Of course, in other embodiments, the lower connection portion 54 may be arranged at other positions of the moving plate 51.

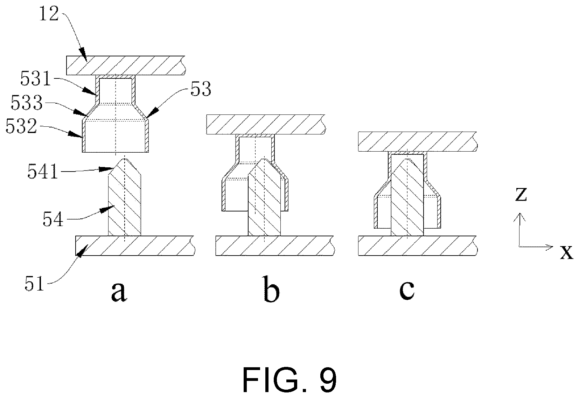

The moving plate 51 is able to move in the plane where the X-axis and the Y-axis are located, to drive the wafer loader 12 to move to the target position by means of an axial connection of the lower connection portion 54 and the upper connection portion 53. As shown in FIG. 9, the upper connection portion 53 at least comprises a first section 531 and a second section 532 which are arranged coaxially, wherein the inner diameter of the first section 531 matches the outer diameter of the lower connection portion 54, that is, the inner diameter of the first section 531 is equal to the outer diameter of the lower connection portion 54 in a case where the lower connection portion 54 is cylindrical. The inner diameter of the second section 532 is greater than the inner diameter of the first section 531, and the second section 532 is close to the lower connection portion 54. In this embodiment, a top end of the lower connection portion 54 is cut into a conical surface 541, and a necking section 533 is formed between the first section 531 and the second section 532. In this way, when the upper connection portion 53 and the lower connection portion 54 are connected axially, the lower connection portion 54 is inserted into the second section 532 first, as shown by a in FIG. 9; then, the conical surface 541 slides along an inner wall of the necking section 533 until the conical surface 541 enters the first section 531, as shown by b in FIG. 9; and finally, the upper connection portion 53 and the lower connection portion 54 are axially connected, as shown by c in FIG. 9.

Of course, in other embodiments, the necking section 533 may function as the second section 532 as long as the inner diameter of the necking section 533 is greater than the inner diameter of the first section 531 to ensure that the lower connection portion 54 can be smoothly inserted into the necking section 533.

Or, the structure of the upper connection portion and the structure of the lower connection portion can be exchanged. That is, the lower connection portion at least comprises a first section and a second section which are arranged coaxially, the inner diameter of the first section matches the outer diameter of the upper connection portion, the inner diameter of the second section is greater than the inner diameter of the first section, and the second section is close to the upper connection portion.

The wafer loader 12 has a micro-motion state where the wafer loader 12 at least can float in the X-axis direction and the Y-axis direction. The wafer loader 12 in the micro-motion state is limited with respect to the fixed base 11 by means of the connection mechanism 5, thus being switched from the micro-motion state to a stationary state. Here, in the micro-motion state of the wafer loader 12, the fixed base 11 and the wafer loader 12 can move slightly with respect to each other although they are connected by means of an existing structure. In the stationary state, the wafer loader 12 will not move at least with respect to the connection mechanism 5.

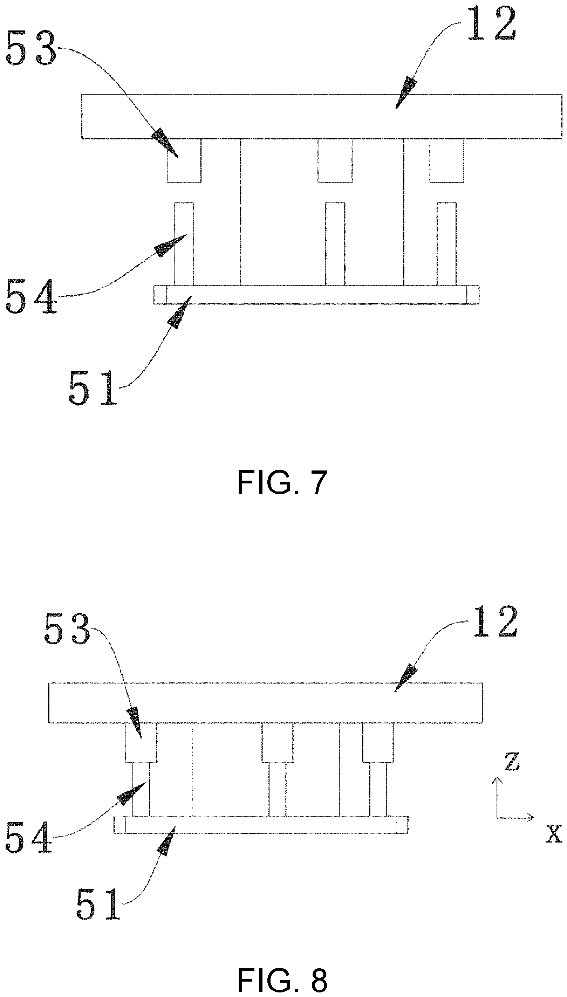

As shown in FIG. 7, when the wafer loader 12 is located at an upper station, the upper connection portion 53 and the lower connection portion 54 are disconnected, and the wafer loader 12 is still in the micro-motion state. As shown in FIG. 8, when the wafer loader 12 descends in position along the Z-axis, the upper connection portion 53 and the lower connection portion 54 are connected, and the wafer loader 12 is switched to the stationary state.

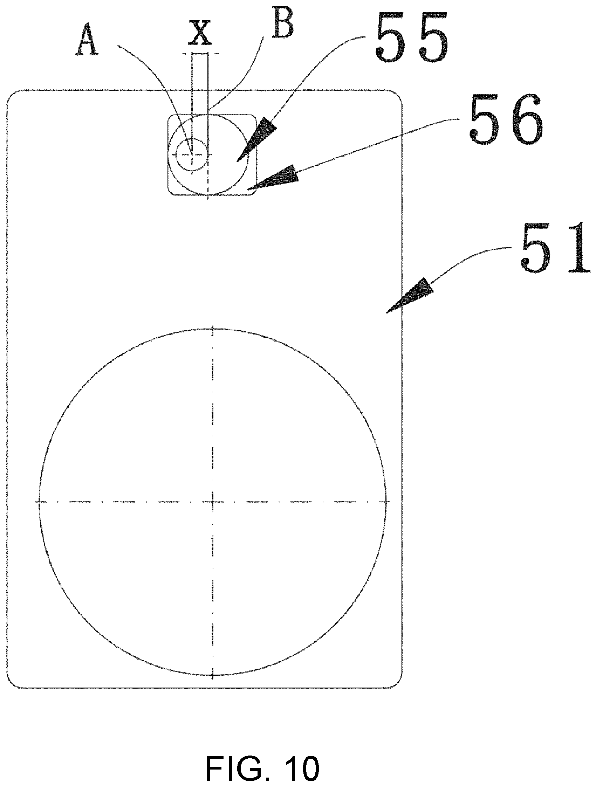

The connection mechanism 5 can move with respect to the fixed base 11 by means of an external force. In this embodiment, a slot 56 is formed in the moving plate 51, and an eccentric cam 55 connected to a motor 551 stretches into the slot 56 and is tangent to an inner wall of the slot 56. Specifically, as shown in FIG. 10, the outer diameter of the eccentric cam 55 is equal to the width of the slot 56, the length of the slot 56 is greater than the outer diameter of the eccentric cam 55, the axis of an output shaft of the motor 551 is located at a point A, a tangent point of the eccentric cam 55 and the slot 56 is located on a normal B, and a deviation between A and B is in the X-axis direction. The position of the motor 551 is fixed relatively. When the motor 551 drives the eccentric cam 55 to rotate, the moving plate 51 moves along the sliding rail 52 in the plane where the X-axis and the Y-axis are located, particularly in the X-axis direction. The moving plate 51 can be stopped freely within the movement range by controlling the rotation angle of the motor 551.

The wafer polishing system further comprises a storage unit used for storing rotation angles of eccentric cam 55 at different stations, such that the eccentric cam 55 can quickly rotate to a target position according to data recorded in the storage unit. As described above, one portion of the connection mechanism 5 moves first in the plane where the X-axis and the Y-axis are located, and after the position of the connection mechanism 5 and the position of the fixed base 11 are fixed relatively, the two portions of the connection mechanism 5 are connected to allow the wafer loader 12 to move the target position, that is, the moving plate 51 is moved to the target position by means of the storage unit, and then the two portions of the connection mechanism 5 are connected. By means of the storage unit, the clamping jaws can be automatically adjusted at different positions, and one wafer loader can correspond to multiple clamping jaws.

In a case where the target position of the wafer loader 12 is the position exactly opposite to the clamping jaws of the clamping mechanism 6, because the existing clamping jaws 6 can only move horizontally in the X-axis direction and ascend and descend in the Z-axis direction and cannot move in the Y-axis direction, two stations are arranged in the Z-axis direction; when located at the upper station, the clamping jaws can move in the X-axis direction to transfer the wafer to different areas; and when located at the lower station, the clamping jaws can pick up the wafer from the wafer loader or place the wafer onto the wafer loader. In this way, the problem that when the fixed base 11 moves in the X-axis direction to different working positions in the wafer transfer channel 3, such as positions where the wafer is picked up or placed by polishing heads of two polishing modules, the wafer loader 12 cannot be aligned with the clamping jaws 6 due to a deviation of the wafer loader 12 in the plane where the X-axis and the Y-axis are located is solved.

To prevent the wafer 2 from being polluted by the clamping jaws 6, at least two clamping jaws 6 are arranged, at least one clamping jaw is used for picking and placing non-polished wafers, and at least one clamping jaw is used for picking and placing polished wafers, that is, a placement clamping jaw is used for placing a to-be-polished wafer on the wafer loader, and a pick-up clamping jaw is used for taking the polished wafer from the wafer loader, and the two clamping jaws are located on two sides of the wafer transfer channel 3 respectively. Of course, in the embodiments, one clamping jaw 6 may be arranged.

A loading method for a wafer polishing system is implemented based on the structure of the above wafer polishing system and comprises:
a step of driving one portion of the connection mechanism 5 to move with respect to the fixed base 11 in the plane where the X-axis and the Y-axis are located;
a step of driving the wafer loader 12 to ascend or descend in the Z-axis direction to be close to the fixed base 11; and
a step of axially connecting the connection mechanism 5 and the wafer loader 12;
wherein, the three steps are performed sequentially, in an overlapped manner, or synchronously;
in this way, the wafer loader 12 is moved to the target position in the plane where the X-axis and the Y-axis are located.

More specifically,
The loading method for a wafer polishing system is implemented based on the structure of the above wafer polishing system and comprises:
a step of driving the moving plate 51 to move with respect to the fixed base 11 in the plane where the X-axis and the Y-axis are located;
a step of driving the wafer loader 12 to ascend or descend in the Z-axis direction to be close to the fixed base 11; and
a step of axially connecting the upper connection portion 53 on a lower side of the wafer loader 12 and the lower connection portion 54 on an upper side of the moving plate 51;
wherein, the three steps are performed sequentially, in an overlapped manner, or synchronously;
in this way, the wafer loader 12 is moved to the target position in the plane where the X-axis and the Y-axis are located.

The loading method for a wafer polishing system is specifically described below with reference to three embodiments.

### Embodiment 1

The loading method for a wafer polishing system is implemented based on the structure of the above wafer polishing system and comprises the following steps:
the moving plate 51 moves with respect to the fixed base 11 in the plane where the X-axis and the Y-axis are located, wherein this movement is defined as a motion A;
the wafer loader 12 starts to ascend or descend in the Z-axis direction to be close to the fixed base 11, wherein this movement is defined as a motion B;
the moving plate 51 further moves with respect to the fixed base 11 in the plane where the X-axis and the Y-axis are located and the wafer loader 12 further ascends or descends in the Z-axis direction to be close to the fixed base 11 (that is, both the motion A and the motion B are performed) until the upper connection portion 53 and the lower connection portion 54 are axially connected;
the moving plate 51 stops moving, that is, the motion A is ended; and
the wafer loader 12 stops ascending or descending, that is, the motion B is ended.

The execution sequences of the motion A and the motion B can be exchanged, and specific details will not be given anymore here.

In this embodiment, the motion time for the whole connection process is short, and the time efficiency is high.

### Embodiment 2

The loading method for a wafer polishing system is implemented based on the structure of the above wafer polishing system and comprises the following steps:
the moving plate 51 moves with respect to the fixed base 11 in the plane where the X-axis and the Y-axis are located, wherein this movement is defined as a motion A;
the moving plate 51 stops moving when moving to the target position, that is, the motion A is ended;
the wafer loader 12 starts to ascend or descend in the Z-axis direction to be close to the fixed base 11, wherein this movement is defined as a motion B; and
the wafer loader 12 stops ascending or descending when the upper connection portion 53 and the lower connection portion 54 are axially connected, that is, the motion B is ended.

In this embodiment, the requirement for the structural design is low, and the position of the wafer loader 12 can be adjusted only by moving the moving plate 51 by means of an external force.

### Embodiment 3

The wafer loader 12 starts to ascend or descend in the Z-axis direction to be close to the fixed base 11, wherein this movement is defined as a motion B;
slide holder 12 stops ascending or descending when the upper connection portion 53 and the lower connection portion 54 are connected, that is, the motion B is ended;
the moving plate 52 drives the wafer loader 12 to move with respect to the fixed base 11 in the Y-axis direction, wherein this movement is defined as a motion A; and
the moving plate 52 stops moving when moving to the target position, that is, the motion A is ended.

In this embodiment, the two portions of the connection mechanisms have been connected and limited before the moving plate 51 moves, such that the moving plate 51 and the wafer loader 12 can be driven to move as a hole by means of an external force.

### Embodiment 4

The wafer polishing system and the loading method therefor are applied to a specific usage scenario, that is, a using method for a wafer polishing system is implemented based on the structure of the above wafer polishing system and the loading method, and comprises:
a step of connecting and limiting the wafer loader 12 and the fixed base 11 by means of the connection mechanism 5 to allow the wafer loader 12 to be located at a position exactly opposite to a target position of a clamping jaw 6, and placing the wafer 2 on the wafer loader 12 by the clamping jaw 6; or, a step of driving, after the wafer loader 12 and the fixed base 11 are connected, the connection mechanism 5 to move in the plane where the X-axis and the Y-axis are located to allow the wafer loader 12 to be located at a position exactly opposite to a clamping jaw 6, and placing the wafer 2 on the wafer loader 12 by the clamping jaw 6;
a step of rotating a polishing head 41 of the polishing module 4 to a position above the wafer loader 12, switching the wafer loader 12 to the micro-motion state where the wafer loader 12 is able to float in the X-axis direction and the Y-axis direction, and taking the wafer from the wafer loader 12 by the polishing head 41; and
a step of connecting and limiting the wafer loader 12 and the fixed base 11 by means of the connection mechanism 5 and driving the wafer loader 12 to move in the X-axis direction to a different station;
wherein, the three steps are performed sequentially; or, any one, two or more of the three steps are combined to be performed; or one, two or more of the three steps are combined repeatedly to be performed;
in this way, a deviation of the wafer loader 12 in the X-axis direction and the Y-axis direction is eliminated to align the wafer loader 12 with the clamping jaw 6.

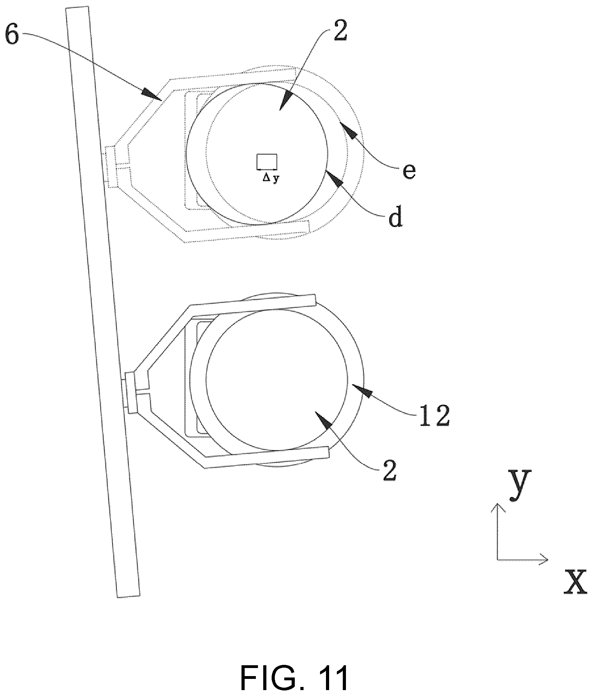

As shown in FIG. 11, the application of this embodiment can eliminate various inevitable errors generated in the production and assembly process of polishing equipment to solve the problem that the clamping jaw 6 and the wafer loader 12 are in different matching states in the X-axis direction and the Y-axis direction, particularly in the Y-axis direction, when the clamping jaw 6 picks up or places the wafer 2 on the wafer loader 12 at different positions in the X-axis direction due to unparallel movement paths of the fixed base 11 in the X-axis direction. For example, as shown in FIG. 11, the desired wafer pickup and placement position is position d, the actual wafer pickup and placement position caused by errors is position e, there is a deviation Δy between the desired wafer pickup and placement position and the actual wafer pickup and placement position in the Y-axis direction, and this embodiment eliminates the deviation Δy and realizes accurate matching between the clamping jaw 6 and the wafer loader 12.

Based on Embodiment 3, the using method for a wafer polishing system is specifically described below with reference to two embodiments.

### Embodiment 5

The using method for a wafer polishing system comprises the following steps:
the wafer loader 12 and the fixed base 11 are connected and limited by means of the connection mechanism 5 to allow the wafer loader 12 to be located at a position exactly opposite to the target position of the clamping jaw 6;
the clamping jaw 6 moves, together with the wafer 2, in the X-axis direction to a position above the wafer loader 12 and ascends or descends in the Z-axis direction to place the wafer 2 on the wafer loader 12;
the polishing head 41 rotates to a position above the wafer loader 12;
the wafer loader 12 ascends or descends in the Z-axis direction to be switched to the micro-motion state in which the wafer loader 12 is able to float in the X-axis direction and the Y-axis direction, and moves to a position corresponding to the polishing head 41 under the constraint of a limiting structure, wherein the limiting structure can be realized in the prior art and will not be detailed anymore;
the wafer loader 12 ascends or descends in the Z-axis direction, and the wafer loader 12 and the fixed base 11 are connected and limited by means of the connection mechanism 5;
the wafer 2 is taken from the wafer loader 12 by the polishing head 41 to be polished;
the wafer loader 12 moves in the X-axis direction to another station;
the wafer loader 12 ascends or descends in the Z-axis direction to be switched to the micro-motion state in which the wafer loader 12 is able to float in the X-axis direction and the Y-axis direction;
one portion (the moving plate 51) of the connection mechanism 5 moves to the target position in the plane where the X-axis and the Y-axis are located under the action of an external force; and
the wafer loader 12 ascends or descends in the Z-axis direction, and the wafer loader 12 and the fixed base 11 are connected and limited by means of the connection mechanism 5 to eliminate a deviation in the X-axis direction and the Y-axis direction to align the wafer loader 12 with another clamping jaw 6.

### Embodiment 6

The using method for a wafer polishing system comprises the following steps:
the wafer loader 12 and the fixed base 11 are connected by means of the connection mechanism 5 to allow the wafer loader 12 to be located at a position exactly opposite to the target position of the clamping jaw 6;
the clamping jaw 6 moves, together with the wafer 2, in the X-axis direction to a position above the wafer loader 12 and ascends or descends in the Z-axis direction to place the wafer 2 on the wafer loader 12, and the clamping jaw 6 is moved away;
the polishing head 41 rotates to a position above the wafer loader 12, and the wafer loader 12 ascends in the Z-axis direction and floats in the plane where the X-axis and the Y-axis are located to be aligned with the polishing head 41;
the wafer 2 is taken from the wafer loader 12 by the polishing head 41;
the wafer loader 12 ascends or descends in the Z-axis direction, and the wafer loader 12 and the fixed base 11 are connected and limited to a desired target position of the wafer loader 12 on a next station, wherein the target position is stored in the storage unit;
the polishing head 41 moves, together with the wafer 2, to a polishing station of the polishing module 4; and
the wafer loader 12 moves in the X-axis direction to another station.

### Embodiment 7

The using method for a wafer polishing system comprises the following steps:
the clamping jaw 6 moves, together with the wafer 2, in the X-axis direction to a position above the wafer loader 12 and ascends or descends in the Z-axis direction to place the wafer 2 on the wafer loader 12;
the polishing head 41 rotates to a position above the wafer loader 12;
the wafer loader 12 ascends or descends in the Z-axis direction to be switched to the micro-motion state in which the wafer loader 12 is able to float in the X-axis direction and the Y-axis direction, and the wafer loader 12 moves to a position corresponding to the polishing head 41 under the constraint of a limiting structure;
one portion (the moving plate 51) of the connection mechanism 5 moves to the target position in the plane where the X-axis and the Y-axis are located under the action of an external force;
the wafer loader 12 ascends or descends in the Z-axis direction, and the wafer loader 12 and the fixed base 11 are connected and limited by means of the connection mechanism 5;
the wafer 2 is taken from the wafer loader 12 by the polishing head 41 to be polished; and
the wafer loader 12 moves in the X-axis direction to another station.

The above specific embodiments are used for the invention rather than limiting the invention. Any modifications and transformations made to the invention based on the spirit and protection scope of the claims should also fall within the protection scope of the invention.

## Claims

1. A wafer polishing system, comprising:
a wafer transfer device (1), comprises a fixed base (11) and a wafer loader (12) for carrying a wafer (2), and the fixed base (11) being able to drive the wafer loader (12) to move in a wafer transfer channel (3) in an X-axis direction; and
a polishing module (4), being arranged on a side of the wafer transfer channel (3) and being able to pick up the wafer (2) from the wafer loader (12) to polish the wafer;
**characterized in that**,
a connection mechanism (5) is arranged between the fixed base (11) and the wafer loader (12), and the connection mechanism (5) has a portion connected to the fixed base (11) and a portion connected to the wafer loader (12);
when the two portions of the connection mechanism (5) are connected, the wafer loader (12) and the fixed base (11) are limited, and the connection mechanism (5) is able to move in a plane where an X-axis and a Y-axis are located to drive the wafer loader (12) to move to a target position in the plane where the X-axis and the Y-axis are located.

2. The wafer polishing system according to Claim 1, **characterized in that**, the connection mechanism (5) comprises:
a sliding plate (51) movably arranged on the fixed base (11) by means of a sliding rail (52);
an upper connection portion (53) arranged on the wafer loader (12); and
a lower connection portion (54) arranged on the moving plate (51);
wherein, the sliding plate (51) is able to move in the plane where the X-axis and the Y-axis are located to drive the wafer loader (12) to move to the target position by means of an axial connection of the lower connection portion (54) and the upper connection portion (53).

3. The wafer polishing system according to Claim 2, **characterized in that**, the upper connection portion (53) at least comprises a first section (531) and a second section (532) which are arranged coaxially, an inner diameter of the first section (531) matches an outer diameter of the lower connection portion (54), an inner diameter of the second section (532) is greater than the inner diameter of the first section (531), and the second section (532) is close to the lower connection portion (54);
or, the lower connection portion at least comprises a first section and a second section which are arranged coaxially, an inner diameter of the first section matches an outer diameter of the upper connection portion, an inner diameter of the second section is greater than the inner diameter of the first section, and the second section is close to the upper connection portion.

4. The wafer polishing system according to Claim 1, **characterized in that**, the wafer loader (12) has a micro-motion state where the wafer loader (12) is able to float at least in the X-axis direction and a Y-axis direction, and the wafer loader (12) in the micro-motion state is limited with respect to the fixed base (11) by means of the connection mechanism to be switched from the micro-motion state to a stationary state.

5. The wafer polishing system according to Claim 2, **characterized in that**, a slot (56) tangent to an eccentric cam (55) is formed in the moving plate (51), and when the eccentric cam (55) is driven to rotate by means of an external force, the moving plate (51) moves in the plane where the X-axis and the Y-axis are located.

6. The wafer polishing system according to Claim 5, **characterized in that**, further comprising a storage unit used for storing rotation angles of the eccentric cam (55) at different stations.

7. The wafer polishing system according to Claim 1, **characterized in that**, the target position is a position exactly opposite to a clamping jaw (6) to overcome a deviation of the wafer loader (12) in the plane where the X-axis and the Y-axis are located when the fixed base (11) moves in the X-axis direction to different stations.

8. The wafer polishing system according to Claim 7, **characterized in that**, at least two said clamping jaws (6) are arranged, at least one said clamping jaw is used for picking and placing non-polished wafers, and at least one said clamping jaw is used for picking and placing polished wafers.

9. A loading method for the wafer polishing system according to any one of Claims 1-8, **characterized in that**, comprising the following steps of:
a step of driving one portion of the connection mechanism (5) to move with respect to the fixed base (11) in the plane where the X-axis and the Y-axis are located;
a step of driving the wafer loader (12) to ascend or descend in a Z-axis direction to be close to the fixed base (11); and
a step of axially connecting the connection mechanism (5) and the wafer loader (12);
wherein, the three steps are performed sequentially, in an overlapped manner, or synchronously;
in this way, the wafer loader (12) is moved to the target position in the plane where the X-axis and the Y-axis are located.

10. The loading method for the wafer polishing system according to Claim 9, **characterized in that**, comprising the following steps of:
a step of driving the moving plate (51) to move with respect to the fixed base (11) in the plane where the X-axis and the Y-axis are located;
a step of driving the wafer loader (12) to ascend or descend in the Z-axis direction to be close to the fixed base (11); and
a step of axially connecting the upper connection portion (53) on a lower side of the wafer loader (12) and the lower connection portion (54) on an upper side of the moving plate (51);
wherein, the three steps are performed sequentially, in an overlapped manner, or synchronously;
in this way, the wafer loader (12) is moved to the target position in the plane where the X-axis and the Y-axis are located.

11. The loading method for the wafer polishing system according to Claim 9, **characterized in that**, comprising the following steps of:
a step of driving the moving plate (51) to move with respect to the fixed base (11) in the plane where the X-axis and the Y-axis are located;
a step of driving the wafer loader (12) to ascend or descend in the Z-axis direction to be close to the fixed base (11);
a step of driving the moving plate (51) to further move with respect to the fixed base (11) in the plane where the X-axis and the Y-axis are located and driving the wafer loader (12) to further ascend or descend in the Z-axis direction to be close to the fixed base (11) until the upper connection portion (53) and the lower connection portion (54) are axially connected;
a step of stopping the moving plate (51) from moving; and
a step of stopping the wafer loader (12) from ascending or descending.

12. The loading method for the wafer polishing system according to Claim 9, **characterized in that**, comprising the following steps of:
a step of driving the moving plate (51) to move with respect to the fixed base (11) in the plane where the X-axis and the Y-axis are located to reach the target position; and
a step of driving the wafer loader (12) to ascend or descend in the Z-axis direction to be close to the fixed base (11) unit the upper connection portion (53) and the lower connection portion (54) are axially connected.

13. The loading method for the wafer polishing system according to Claim 9, **characterized in that**, comprising the following steps of:
a step of driving the wafer loader (12) to ascend or descend in the Z-axis direction to be close to the fixed base (11) until the upper connection portion (53) and the lower connection portion (54) are connected; and
a step of driving, by the moving plate (51), the wafer loader (12) to move with respect to the fixed base (11) in the Y-axis direction to reach the target position.

14. A using method for the wafer polishing system according to any one of Claims 1-8, **characterized in that**, comprising the following steps of:
a step of connecting and limiting the wafer loader (12) and the fixed base (11) by means of the connection mechanism (5) to allow the wafer loader (12) to be located at a position exactly opposite to a target position of a clamping jaw (6) and placing the wafer (2) on the wafer loader (12) by the clamping jaw (6);
a step of rotating a polishing head (41) of the polishing module (4) to a position above the wafer loader (12), switching the wafer loader (12) to the micro-motion state where the wafer loader (12) is able to float in the X-axis direction and the Y-axis direction and taking the wafer from the wafer loader (12) by the polishing head (41); and
a step of connecting and limiting the wafer loader (12) and the fixed base (11) by means of the connection mechanism (5) and driving the wafer loader (12) to move in the X-axis direction to a different station;
wherein, the three steps are performed sequentially; or, any one, two or more of the three steps are combined to be performed; or one, two or more of the three steps are combined repeatedly to be performed;
in this way, a deviation of the wafer loader (12) in the X-axis direction and the Y-axis direction is eliminated to align the wafer loader (12) with the clamping jaw (6).

15. The using method for the wafer polishing system according to Claim 14, **characterized in that**, comprising the following steps of: a step of moving, after the two portions of the connection mechanism (5) are connected, the connection mechanism (5) in the plane where the X-axis and the Y-axis are located to allow the wafer loader (12) to be located at a position exactly opposite to the clamping jaw (6), and placing the wafer (2) on the wafer loader (12) by the clamping jaw (6).

16. The using method for the wafer polishing system according to Claim 14, **characterized in that**, comprising the following steps of:
a step of connecting and limiting the wafer loader (12) and the fixed base (11) by means of the connection mechanism (5) to allow the wafer loader (12) be located at a position exactly opposite to the clamping jaw (6);
a step of driving the clamping jaw (6), together with the wafer (2), to move in the X-axis direction to a position above the wafer loader (12) and then driving the clamping jaw (6) to ascend or descend in a Z-axis direction to place the wafer (2) on the wafer loader (12);
a step of rotating the polishing head (41) to a position above the wafer loader (12);
a step of driving the wafer loader (12) to ascend or descend in the Z-axis direction to be switched to the micro-motion state where the wafer loader (12) is able to float in the X-axis direction and the Y-axis direction, and moving the wafer loader (12) to a position corresponding to the polishing head (41) under the constraint of a limiting structure;
a step of driving the wafer loader (12) to ascend or descend in the Z-axis direction and connecting and limiting the wafer loader (12) and the fixed base (11) by means of the connection mechanism (5);
a step of taking the wafer (2) from the wafer loader (12) by the polishing head for polishing;
a step of moving the wafer loader (12) in the X-axis direction to another station;
a step of driving the wafer loader (12) to ascend or descend in the Z-axis direction to be switched to the micro-motion state where the wafer loader (12) is able to float in the X-axis direction and the Y-axis direction;
a step of driving, by means of an external force, one portion of the connection mechanism (5) to move to the target position in the plane where the X-axis and the Y-axis are located; and
a step of driving the wafer loader (12) to ascend or descend in the Z-axis direction, and connecting and limiting the wafer loader (12) and the fixed base (11) by means of the connection mechanism (5) to eliminate a deviation in the X-axis direction and the Y-axis direction to align the wafer loader (12) with another clamping jaw (6).

17. The using method for the wafer polishing system according to Claim 14, **characterized in that**, comprising the following steps of:
a step of limiting and connecting the wafer loader (12) and the fixed base (11) by means of the connection mechanism (5) to allow the wafer loader (12) to be located at a position exactly opposite to the target position of the clamping jaw (6);
a step of driving the clamping jaw (6), together with the wafer (2), to move in the X-axis direction to a position above the wafer loader (12), driving the clamping jaw (6) to ascend or descend in a Z-axis direction to place the wafer (2) on the wafer loader (12), and moving the clamping jaw (6) away;
a step of rotating the polishing head (41) to a position above the wafer loader (12), and driving the wafer loader (12) to ascend in the Z-axis direction and float in the plane where the X-axis and the Y-axis are located to be aligned with the polishing head (41);
a step of taking the wafer (2) from the wafer loader (12) by the polishing head (41);
a step of driving the wafer loader (12) to ascend or descend in the Z-axis direction, and connecting and limiting the wafer loader (12) and the fixed base (11) to a desired target position of the wafer loader (12) on a next station, wherein the target position is stored in the storage unit;
a step of moving the polishing head (41), together with the wafer (2), to a polishing station of the polishing module (4); and
a step of moving the wafer loader (12) in the X-axis direction to another station.
